# EUROPÄISCHE PATENTSCHRIFT

(11) **EP 2 170 763 B1**
(45) Veröffentlichungstag und Bekanntmachung des Hinweises auf die Patenterteilung: **27.05.2015**
(21) Anmeldenummer: 08734873.6
(22) Anmeldetag: 28.03.2008
(51) Int. Cl.: B81B 7/00

(54) **VERFAHREN ZUR HERSTELLUNG VON LEITERBAHNBRÜCKEN UND BAUTEIL MIT LEITFÄHIGER SCHICHT**
METHOD FOR THE PRODUCTION OF A COMPONENT, AND COMPONENT
PROCÉDÉ DE PRODUCTION D'UN COMPOSANT, ET COMPOSANT OBTENU

(30) Priorität: 29.06.2007 DE 102007030121
(43) Veröffentlichungstag der Anmeldung: 07.04.2010
(73) Patentinhaber: Northrop Grumman LITEF GmbH, 79115 Freiburg (DE)
(72) Erfinder: GEIGER, Wolfram, 79112 Freiburg (DE); BRENG, Uwe, 79194 Gundelfingen (DE)
(74) Vertreter: Müller Hoffmann & Partner
(86) Internationale Anmeldenummer: PCT/EP2008/002503
(87) Internationale Veröffentlichungsnummer: WO 2009/003542

(56) Entgegenhaltungen:
- EP-A- 1 405 821
- DE-A1-102005 015 584
- US-A1- 2004 104 444

## Beschreibung

Die Erfindung bezieht sich auf ein Verfahren zur Herstellung von mikromechanischen, mikro-elektromechanischen (MEMS) bzw. mikro-opto-elektromechanischen (MOEMS) Bauteilen sowie ein derartiges Bauteil.

Um Umwelteinflüsse wie Feuchtigkeit und Verunreinigungen (z.B. Staub) auf mikroelektromechanische Bauteilen (MEMS) bzw. mikro-opto-elektromechanische Bauteilen (MOEMS) möglichst gering zu halten, werden aktive Strukturen derartiger Bauteile häufig hermetisch abgekapselt. Unter "aktiver Struktur" sind hier insbesondere bewegliche Strukturen, optische Strukturen oder Strukturen, die gleichermaßen bewegliche und optische Komponenten aufweisen (z.B. bewegliche Spiegel) zu verstehen. Der Begriff "aktives Gebiet" bezeichnet das Gebiet bzw. Volumen des Bauteils, in dem die aktive Struktur liegt bzw. sich bewegt. Die hermetisch dichte Verkapselung kann weiterhin zur Einstellung eines bestimmten Innendrucks im Bereich der aktiven Strukturen genutzt werden, was insbesondere bei Bauteilen, deren Funktionsweise von einem definierten Innendruck abhängt, wie z.B. Beschleunigungssensoren und Gyroskopen (Drehraten-Sensoren), vorteilhaft ist.

Damit möglichst kostengünstig produziert werden kann, erfolgt die Fertigung von MEMS- bzw. MOEMS-Bauteilen in der Regel auf Wafer-Ebene. Die dabei häufig durchzuführenden Fügeprozesse können beispielsweise auf Basis von Dircktbondprozessen sowie anodischen Bondprozessen erfolgen.

Die Herausführung elektrischer Kontakte aus dem hermetisch dichten Bereich des Bauteils zur Kontaktierung von bestimmten Teilen des Bauteils (z.B. zur Kontaktierung der aktiven Struktur) ist fertigungstechnisch schwierig zu realisieren. Es kommen verschiedene Möglichkeiten in Betracht: Die elektrischen Kontakte können beispielsweise durch lateral verlaufende, mittels Implantations- bzw. Diffusionsverfahren hergestellte Halbleiterschichten mit niedrigem Schichtwiderstand realisiert werden. Weiterhin ist eine Realisierung durch strukturierte, mit einer planarisierten Passivierungsschicht bedeckte leitfähige Schichten möglich.

Alternativ können die elektrischen Kontakte in Form mehrerer vertikal verlaufender Durchkontaktierungen aus dem Bauteil herausgeführt werden.

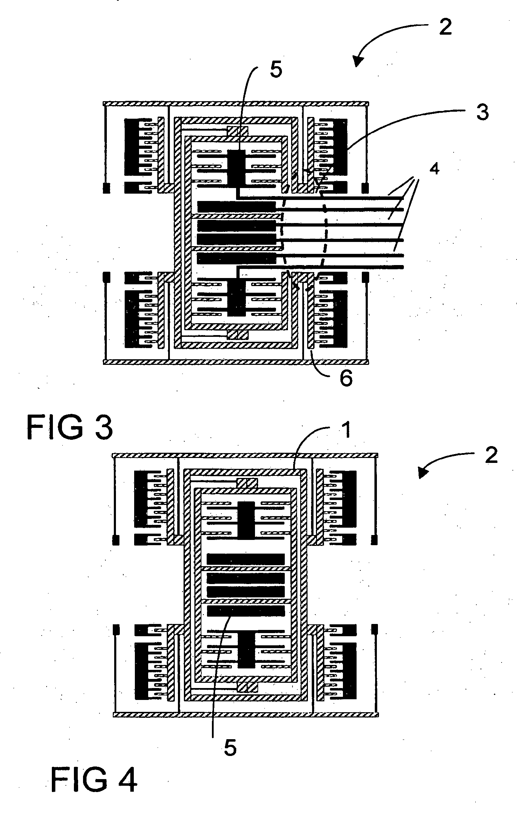

Aus DE102005015584 ist ein Verfahren zur Herstellung eines Bauteils beschrieben, bei dem das aktive Gebiet und damit die aktive Struktur des Bauteils von der Umwelt des Bauteils isoliert wird (was Verunreinigungen und Feuchtigkeit anbelangt), bevor die Erzeugung der Kontaktlöcher erfolgt. Elektrische Ströme, die die aktive Struktur zum Betrieb des Bauteils benötigt bzw. Signale, die durch die aktive Struktur erzeugt werden, werden über die Kontaktlöcher und über die sich daran anschließende leitfähige Strukturschicht der aktiven Struktur zugeführt bzw. von dieser abgegriffen. Allerdings ermöglicht die beschriebene Technologie keine Kreuzung von Leiterbahnen. Insbesondere ist es nicht möglich. Bereiche (z.B. Elektroden), die innerhalb einer (in einer Bauteilschicht-Ebene) geschlossenen beweglichen Struktur liegen, mit vertretbar kleinem Flächenbedarf zu kontaktieren. Daher weisen die mit dieser Technologie realisierten beweglichen Strukturen 6 in MEMS 2 häufig Öffnungen 3 für die Leiterbahnen 4 zu Elektroden 5 auf (s. Figur 3).

Es ist daher die Aufgabe der Erfindung, ein Verfahren zum Herstellen eines Bauteils, insbesondere eines mikromechanischen, mikro-elektromechanischen oder mikro-opto-elektromechanischen Bauteils sowie ein solches Bauteil anzugeben, mit dem Leiterbahnkreuzungen und insbesondere Brücken über bewegliche Strukturen realisiert werden können.

Die Aufgabe wird erfindungsgemäß gelöst durch ein Verfahren der eingangs genannten Art mit den Merkmalen des Patentanspruchs 1 sowie durch ein Bauteil der eingangs genannten Art mit den Merkmalen des Patentanspruchs 12.

Dabei wird ein erster Schichtverbund erzeugt, der ein erstes Substrat aufweist, auf diesem ersten Substrat eine erste Isolationsschicht und auf dieser ersten Isolationsschicht eine zumindest teilweise leitfähige Deckschicht, es werden erste Vertiefungen und zweite Vertiefungen in der Deckschicht erzeugt, wobei die ersten Vertiefungen eine erste Ätztiefe und die zweiten Vertiefungen eine gegenüber der ersten Ätztiefe geringere zweite Ätztiefe aufweisen, und die erste Ätztiefe mindestens gleich der Dicke der Deckschicht ist, und es wird eine zumindest teilweise leitfähige Strukturschicht auf die Deckschicht derart aufgebracht, dass die Strukturschicht zumindest bereichsweise an die Deckschicht angrenzt.

Durch die unterschiedlichen Ätztiefen werden sogenannte Leiterbahnbrücken realisiert, mit denen die Strukturen überbrückt werden.

Durch das erfindungsgemäße Verfahren wird die Designfreiheit bzw. die Designvielfalt erhöht, da neue Strukturen möglich werden. Durch fehlende Öffnungen wird eine steifere Struktur bewirkt, was zur Reduzierung von parasitären Bewegungen und Effekten führt. Außerdem lässt sich die Anzahl von Bondpads reduzieren, wodurch geringere Kosten durch einen geringeren Flächenbedarf und eine Erhöhung der Ausbeute bzw. Zuverlässigkeit entstehen.

In einer bevorzugten Ausgestaltung des Verfahrens bzw. des Bauteils wird die aktive Struktur des erfindungsgemäß hergestellten Bauteils durch Strukturieren der Strukturschicht erzeugt, wobei das Strukturieren vor oder nach Aufbringen der Strukturschicht auf den ersten Schichtverbund erfolgen kann. Die Strukturierung kann beispielsweise durch Aufbringen einer Maske auf der Oberfläche der Strukturschicht und anschließendem Ätzen der Strukturschicht erfolgen. Wenn die Strukturschicht erst nach dem Aufbringen strukturiert wird, so müssen beim Aufbringen der Strukturschicht keine Fügetoleranzen berücksichtigt werden.

Gemäß weiterer vorteilhafter Ausgestaltungen des Verfahrens bzw. des Bauteils wird durch das Aufbringen einer Kapselschicht bzw. eines zweiten Schichtverbundes eine hermetisch dichte Verkapselung auf Waferebene mit einem einstellbaren Innendruck ermöglicht und gleichzeitig die Möglichkeit geboten, eine von den anderen elektrischen Kontakten elektrisch isolierte Schirmung zum Schutz gegen äußere elektromagnetische Störfelder zu erzeugen. Dabei kann die Strukturschicht auch Teil des zweiten Schichtverbundes sein, welcher darüber hinaus ein zweites Substrat und eine zweite Isolationsschicht aufweist.

Ein einfacher Zugang zu den Metall-Kontaktierungsflächen durch die Kapselschicht lässt sich durch Kontaktlöcher erzielen, welche vor dem Aufbringen der Kapselschicht auf die Strukturschicht in der Kapselschicht erzeugt wurden.

Bei Verwendung des zweiten Schichtverbundes werden vorzugsweise in der der Strukturschicht zugewandten Seite des zweiten Substrats vor Aufbringen der Strukturschicht auf den zweiten Schichtverbund dritte Vertiefungen erzeugt, deren laterale Positionen wenigstens teilweise den lateralen Positionen der Kontaktlöcher entsprechen, die später im zweiten Substrat ausgebildet werden. Die dritten Vertiefungen können in einem späteren Prozessstadium des erfindungsgemäßen Herstellungsverfahrens als Kontaktlöcher (oder zumindest als Teile der Kontaktlöcher) verwendet werden.

In vorteilhafter Weise werden in der der Strukturschicht zugewandten Seite des zweiten Substrats vor Aufbringen der Strukturschicht auf den zweiten Schichtverbund vierte Vertiefungen erzeugt, deren laterale Positionen wenigstens teilweise den lateralen Positionen der aktiven Struktur bzw. der aktiven Struktur der Strukturschicht entsprechen, entsprechend können die zweiten Vertiefungen ebenfalls an diesen lateralen Positionen erzeugt werden. Die zweiten bzw. vierten Vertiefungen ermöglichen eine mechanische Bewegung (z.B. eine Schwingung) des innerhalb des aktiven Gebiets liegenden Bereichs der Strukturschicht. Weiterhin können die zweiten bzw. vierten Vertiefungen zur Einstellung bestimmter Parameter des Bauteils herangezogen werden: Da die mechanische Schwingungsgüte bei bestimmten Bedingungen vor allem von dem in das Bauteil eingeschlossenen Druck, von der Geometrie der aktiven (beweglichen) Struktur und deren unmittelbarer Umgebung abhängt, ist es beispielsweise möglich, durch die Wahl der Ausmaße der zweiten bzw. vierten Vertiefungen die Schwingungsgüte einer schwingungsfähigen aktiven Struktur gezielt zu beeinflussen. So ist die Schwingungsgüte umso größer, je tiefer die zweiten bzw. vierten Vertiefungen sind (bei gleichem Druck innerhalb des Bauteils).

Bei einer symmetrischen Anordnung durch gleiche Ätztiefen der zweiten und vierten Vertiefungen ergibt sich eine symmetrische Gas-Umgebung der beweglichen aktiven Struktur. Dadurch werden resultierende Dämpfungskräfte senkrecht zur Ebene der Schichten und daraus resultierende parasitäre Bewegungen weitgehend unterdrückt.

Sind dritte Vertiefungen innerhalb des zweiten Substrats ausgebildet worden, so kann zum Ausbilden der Kontaktlöcher, ausgehend von der der Strukturschicht abgewandten Oberfläche des zweiten Substrats wenigstens ein Teil des zweiten Substrats bis zu einer vertikalen Position, die der vertikalen Position der Böden der dritten Vertiefungen entspricht, entfernt werden. Damit werden die dritten Vertiefungen "geöffnet" und stehen als Kontaktlöcher zur Verfügung.

Ebenfalls können sich ein Teil der ersten Vertiefungen und ein Teil der dritten Vertiefungen oberhalb bzw. unterhalb der aktiven Struktur befinden.

In einer besonders bevorzugten Ausführungsform bestehen sowohl das erste und das zweite Substrat als auch die Strukturschicht und die Deckschicht aus Silizium. Die Erfindung ist jedoch nicht hierauf beschränkt, auch andere Materialien/ Materialkombinationen sind denkbar. Silizium hat generell die Vorteile guter mechanischer Eigenschaften, hoher Verfügbarkeit und gut entwickelter Bearbeitungsverfahren. Bestehen die oben genannten Komponenten aus Silizium, so hat dies folgende Vorteile: geringe thermische Spannung (dieser Vorteil liegt immer vor, wenn beide Substrate sowie Deck- und Strukturschicht aus demselben Material sind) sowie geringe Ausgasung während des thermischen Fügeprozesses (verglichen zu Pyrex oder SD2 (beide Materialien sind Gläser, die von den Firmen "Corning Glas" bzw. "Hoya" vertrieben werden)), womit sich Drücke kleiner 0.01 mbar innerhalb des Bauteils realisieren lassen.

In vorteilhafter Weise lassen sich die unterschiedlichen Ätztiefen durch einen zweistufigen Trockenätzschritt durch eine Doppelmaske erzeugen.

Durch Erzeugen von Elektroden für die aktive Struktur an den Positionen der zweiten Vertiefungen in/auf der Deckschicht lassen sich vergrabene Elektroden realisieren, mit welchen Bewegungen und Kräfte senkrecht zur Waferebene detektiert bzw. eingeprägt werden können.

Durch einen dreistufigen Ätzprozess können sowohl vergrabene Elektroden als auch Leiterbahnbrücken gemeinsam in einem Bauteil realisiert werden.

Anhand der Figuren der Zeichnung wird die Erfindung durch Ausführungsbeispiele näher erläutert, dabei zeigen
Figur 1 einen Prozessablauf mit Schritten 1-1, 1-2, 1-3, 1-4 und 1-5 zum Strukturieren von Vertiefungen mit unterschiedlichen Ätztiefen mithilfe einer Doppelmaske,
Figur 2 einen Prozessablauf des erfindungsgemäßen Verfahrens anhand von Schnittdarstellungen 2-1, 2-2, 2-3 und 2-4
Figur 3 eine schematische Draufsicht auf eine mikromechanische Sensorstruktur mit Öffnungen für die Leiterbahnen wie im Stand der Technik,
Figur 4 eine schematische Draufsicht auf eine erfindungsgemäße vergleichbare Sensorstruktur, die mit dem erfindungsgemäßen Verfahren erzeugt wurde,
Figur 5 eine Schnittdarstellung eines Bauteils mit vergrabener Elektrode,
Figur 6 eine Schnittdarstellung eines Bauteils mit vergrabener Elektrode und mit einer Leiterbahnbrücke,
Figur 7a eine weitere Schnittdarstellung eines Bauteils mit einer Leiterbahnbrücke entlang der Schnittfläche I-I' der Figur 7b und
Figur 7b einen schematischen Querschnitt eines Bauteils entlang der Schnittfläche II-II' der Figur 7a, überlagert von einem Schnitt entlang der Fläche III-III' der Figur 7a (heller Grauton) und einem Schnitt entlang der Fläche IV-IV' der Figur 7a (dunkler Grauton).

In den Figuren sind identische bzw. einander entsprechende Bereiche. Bauteile sowie Bauteilgruppen mit denselben Bezugsziffern gekennzeichnet.

Bei der vorliegenden Erfindung kann beispielsweise für einen ersten Schichtverbund ein sogenannter Cover-Wafer 10, insbesondere ein SOI-Wafer (SOI: Silicon on Insulator) verwendet werden, der mit einem zweistufigen Strukturierungsschritt, beispielsweise einem zweistufigen Trockenätz-Schritt (DRIE: Deep Reactive Ion Etching) über eine Doppelmaske strukturiert wird. Der SOI-Wafer 10 besteht dabei aus einem ersten Silizium-Substrat 11, einer ersten Isolationsschicht 12, in der Regel Silizium-Dioxid, und einer Deckschicht 13, die vom ersten Substrat 11 durch die vergrabene erste Isolationsschicht 12 getrennt ist.

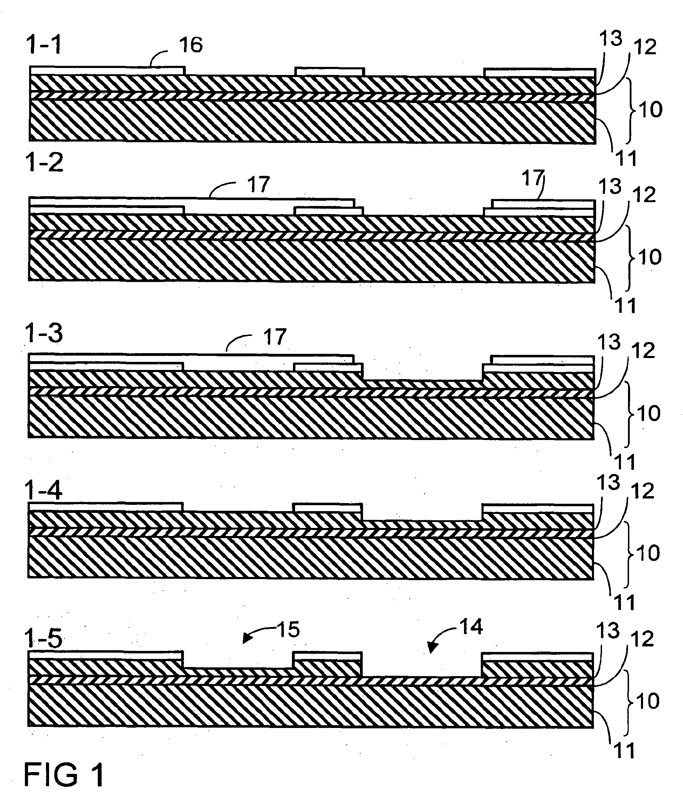

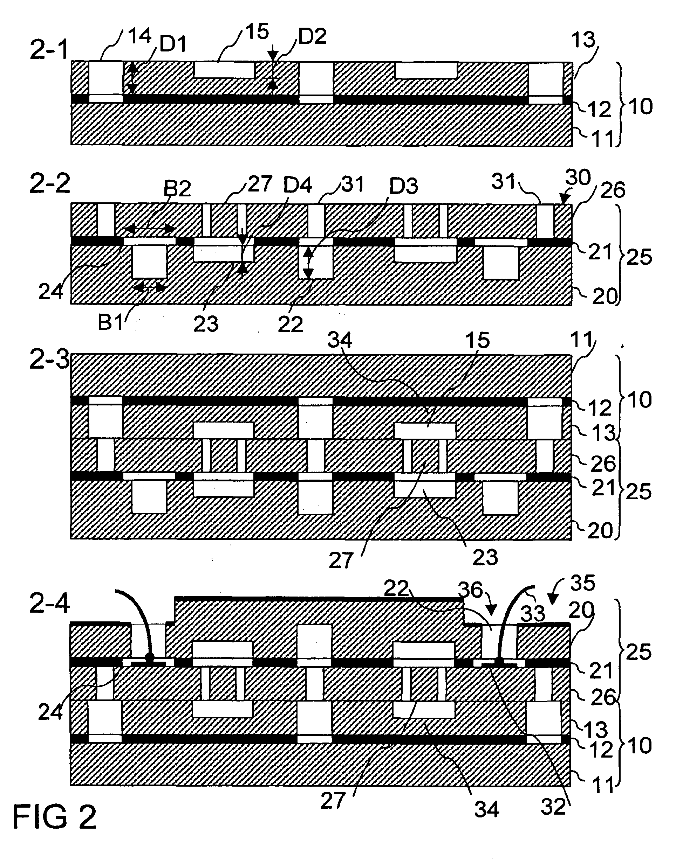

In Figur 1 ist dargestellt, wie eine erste Vertiefung 14 mit einer ersten Ätztiefe D1 und eine zweite Vertiefung 15 mit einer zweiten Ätztiefe D2 realisiert werden (das Ergebnis ist in Schritt 1-5 dargestellt). Zunächst wird eine Oxidschicht 16 auf dem SOI-Wafer 10 realisiert und strukturiert (Schritt 1-1). Anschließend wird eine Schicht Photolack 17 aufgebracht, belichtet und entwickelt (Schritt 1-2). Beim folgenden Strukturierungs-Schritt werden die Bereiche im Silizium der Deckschicht 13 geätzt, die an derselben Stelle in der Oxidschicht 16 und in der Photolackmaske 17 Öffnungen aufweisen, im Beispiel an der lateralen Position der späteren ersten Vertiefung 14 (Schritt 1-3). Nach dem ersten Strukturierungs-Schritt wird der Photolack 17 entfernt (Schritt 1-4). Dabei werden Öffnungen in der Oxidschicht 16 freigelegt, die zuvor mit Photolack 17 bedeckt waren. Im zweiten Strukturierungs-Schritt werden diese Bereiche und die bereits im ersten Strukturierungs-Schritt strukturierten Bereiche in das Silizium der Deckschicht 13 geätzt. Nach beiden Ätzschritten sind die bereits beim ersten Strukturierungs-Schritt strukturierten Bereiche der ersten Vertiefungen 14 bis auf das vergrabene Oxid 12 des SOI-Wafer geöffnet, um eine elektrische Isolierung verschiedener Elektroden zu ermöglichen. Die Tiefe des zweiten Ätzschritts bestimmt den späteren Abstand zwischen einer Brücke und der beweglichen Struktur (bzw. der Leiterbahn in der Strukturschicht 26) (Schritt 1-5), wie im folgenden anhand der Figur 2 ersichtlich ist. Das vergrabene Oxid 12 wirkt als Ätzstopp.

Im nächsten Schritt wird das Oxid 16 entfernt (da die darunter liegende Siliziumoberfläche später gebondet wird, erfolgt die Entfernung vorzugsweise nasschemisch). Dabei wird auch das vergrabene Oxid 12 an den Böden der ersten Vertiefungen 14 ganz (s. Abb. 2-1) oder teilweise entfernt. Dies hat jedoch keine nachteilige Auswirkung auf die Funktion. Der Cover-Wafer 10 hat dann die in Figur 2-1 dargestellte Struktur mit ersten Vertiefungen 14 mit einer ersten Ätztiefe D1, die der Dicke der Deckschicht 13 entspricht und somit mindestens bis auf das vergrabene Oxid 12 reichen und mit zweiten Vertiefungen 15 mit einer gegenüber der ersten Ätztiefe D1 geringeren zweiten Ätztiefe D2.

In einem nächsten Prozessschritt wird auf der Oberfläche eines zweiten Substrats 20 eine strukturierte zweite Isolationsschicht 21 erzeugt. Anschließend werden in der Oberfläche des zweiten Substrats 20 dritte Vertiefungen 22 mit einer dritten Ätztiefe D3 sowie vierte Vertiefungen 23 mit einer vierten Ätztiefe D4 erzeugt. Die Breiten B1 der dritten Vertiefungen 22 fallen hierbei kleiner als die Breiten B2 der Aussparungen der zweiten Isolationsschicht 21 oberhalb der dritten Vertiefungen 22 aus. Auf diese Art und Weise entstehen in den an die dritten Vertiefungen 22 angrenzenden Bereichen Abrisskanten 24, deren Funktion später beschrieben wird.

Zum Erzeugen eines zweiten Schichtverbundes 25 wird auf die weitere Isolationsschicht 21 in einem nächsten Prozessschritt eine Strukturschicht 26 aufgebracht, wobei die Strukturschicht 26 auf den einzelnen Bereichen der zweiten Isolationsschicht 21 aufliegt.

In einem folgenden Prozessschritt wird die Strukturschicht 26 so strukturiert, dass eine aktive Struktur 27 entsteht, wobei äußere Bereiche 30 (der Chiprand, d.h. der Randbereich des herzustellenden Bauteils) der Strukturschicht 26 durch Gräben 31 von den leitfähigen Bereichen "innerhalb" des Bauteils elektrisch isoliert sind. Anschließend ist der in Figur 2-2 dargestellte Aufbau entstanden.

In einem nächsten Prozessschritt, dessen Ergebnis in Figur 2-3 dargestellt ist, werden der erste Schichtverbund 10 und der zweite Schichtverbund 25 aneinander gefügt, derart, das die Deckschicht 13 an die Strukturschicht 26 angrenzt und die zweiten Vertiefungen 15 bzw. die vierten Vertiefungen 23 oberhalb bzw. unterhalb der aktiven Struktur 27 zu liegen kommen. Nicht dargestellt, aber teilweise ebenfalls gewünscht ist, dass sich auch zumindest ein Teil der ersten Vertiefungen 14 und ein Teil der dritten Vertiefungen 22 oberhalb bzw. unterhalb der aktiven Struktur 27 befinden.

Beim Bonden des ersten Schichtverbundes 10 auf den zweiten Schichtverbund 25 "SOI with burried cavities" wird Silizium auf Silizium gebondet, und nicht Silizium auf Oxid. Neben dem hermetisch dichten mechanischen Bond muss dabei eine elektrisch möglichst niederohmige Verbindung hergestellt werden.

In einem nächsten Prozessschritt wird ein Bondpadbereich 35 des zweiten Substrats 20 bis auf eine vertikale Position zurückgeätzt, die der vertikalen Position der Böden der dritten Vertiefungen 22 entspricht, so dass die dritten Vertiefungen 22 freigelegt werden und Kontaktlöcher 36 entstehen.

Nun erfolgt im nächsten Prozessschritt die Abscheidung einer Metallisierungsschicht auf der Oberfläche des zweiten Substrats 20, wobei aufgrund des Vorhandenseins der Abrisskanten 24 der innerhalb der dritten Vertiefungen 22 abgeschiedene Teil der Metallisierungsschicht vom Rest der Metallisierungsschicht elektrisch getrennt wird, so dass innerhalb der dritten Vertiefungen 22 Metall-Kontaktierungsflächen 32 entstehen. Anschließend werden die Metall-Kontaktierungsflächen 32 durch Bonddrähte 33 kontaktiert, wodurch sich die Struktur der Figur 2-4 ergibt.

Falls gewünscht kann in einem weiteren Prozessschritt auf der Strukturschicht 26 abgewandten Oberfläche des ersten Substrats 11 eine weitere Metallisierungsschicht abgeschieden werden (nicht dargestellt). Die weitere Metallisierungsschicht sowie die Metallisierungsschicht dienen als Abschirmelektroden zur Abschirmung unerwünschter elektromagnetischer Felder. Die beiden Metallisierungsschichten können auf ein definiertes, gemeinsames Potenzial bzw. auf unterschiedliche Potenziale gelegt werden.

Erfindungsgemäß wurde demnach ein Verfahren zur Herstellung mikroelektromechanischer bzw. mikro-opto-elektromechanischer Bauteile, insbesondere Bauteile mit hermetisch dicht verkapselten aktiven Strukturen und Flächen zur elektrischen Kontaktierung derselben beschrieben. Das erfindungsgemäße Herstellungsverfahren ermöglicht eine hermetisch dichte Verkapselung bestimmter Bereiche der Strukturschicht auf Waferebene mit einem einstellbaren Innendruck und bietet die Möglichkeit durch Leiterbahnbrücken 34 über aktive Strukturen 27, wie sie exemplarisch in Figur 2-4 gezeigt werden, die Elektroden 5 in der Strukturschicht zu verbinden, ohne dass Öffnungen 3 wie in Figur 3 dargestellt, vorgesehen werden müssen. Dadurch lassen sich Strukturen 1 wie in Figur 4 dargestellt realisieren, bei denen die Elektroden 5 über die Leiterbahnbrücken 34 kontaktiert werden können (hier nicht dargestellt) und dadurch die Strukturen 1 nicht unterbrochen sind im Vergleich zu den offenen Strukturen 6 der Fig.3.

Zur Isolierung des leitfähigen Materials des zweiten Substrats werden vorteilhafterweise Abrisskanten 24 eingesetzt, über die eine galvanische Trennung der elektrisch leitenden Seitenwände des Kontaktlochs 36 gegenüber dem Kontaktlochboden, der (oftmals direkt) mit einer Elektrode des Bauteils verbunden ist, bewirkt wird.

Die Metallisierung der Kontaktbereiche wird erst nach Abschluss sämtlicher Fügeprozesse durchgeführt. Somit können Verfahren wie beispielsweise Silizium-Direkt-Bonden (SDB) mit Temperaturbelastungen größer als 400°C eingesetzt werden, sofern keine dotierten aktiven Gebiete innerhalb der Strukturschicht 26 existieren, deren Dotierungsprofile bei höheren Temperaturen beeinträchtigt werden könnten.

Die Erfindung lässt sich auf den Herstellungsprozess beliebiger (miniaturisierter) Bauteile anwenden, insbesondere auf den Herstellungsprozess eines mikromechanischen, mikro-elektromechanischen oder mikro-opto-elektromechanischen Bauteils, wie Beschleunigungssensoren, Drehratensensoren, Drucksensoren, optische Koppler, etc.

In Abbildung 2-2 bis 2-4 ist der optionale Fall dargestellt, dass auch das zweite Substrat 20 (vor der Realisierung der Strukturschicht 26) durch einen zweistufigen DRIE-Schritt strukturiert wird. Dabei werden die erste Ätztiefe D1 und die dritte Ätztiefe D3 gleich gewählt und auch die zweite Ätztiefe D2 gleich der vierten Ätztiefe D4. Dies hat den Vorteil einer symmetrischen Gas-Umgebung der aktiven Struktur 27. Dadurch werden resultierende Dämpfungskräfte senkrecht zur Waferebene und daraus resultierende parasitäre Bewegungen weitgehend unterdrückt.

Wenn keine hermetisch dichte Verkapselung der Strukturen in der Strukturschicht 26 erforderlich ist, kann auf dem beschriebenen ersten Schichtverbund 10 durch SDB (Silicon Direct Bonding) die Strukturschicht 26 realisiert und (nach der Realisierung von Bondpads z.B. durch Aluminium Sputtern und Ätzen) strukturiert werden.

Es ist auch möglich auf dem oben beschriebenen ersten Schichtverbund 10 eine Strukturschicht 26 zu realisieren und anschließend zu strukturieren. Durch SDB, anodisches Bonden, anodisches Bonden mit z.B. gesputterten PyrexZwischenschicht oder andere Fügeverfahren kann anschließend eine Kapselung durch eine Kapselschicht (z.B. ein zweites Substrat 20) realisiert werden. Dabei kann die Kapselschicht (z.B.20) vorstrukturiert sein, um Zugang zu den Metall-Kontaktierungsflächen 32 zu gewährleisten.Diese Variante führt zu ähnlichen bzw. gleichen Querschnitten wie in Figur 2-4 gezeigt. Auf diesem Wege können die Metall-Kontaktierungsflächen 32 bereits vor der Kapselung auf die Strukturschicht 26 aufgebracht werden, und die aktive Struktur 27 kann getestet werden. Allerdings sind dann für den letzten Fügeprozess Niedertemperaturfügeverfahren einzusetzen, um zu verhindern, dass die Metall-Kontaktierungsflächen 32 dabei zerstört werden.

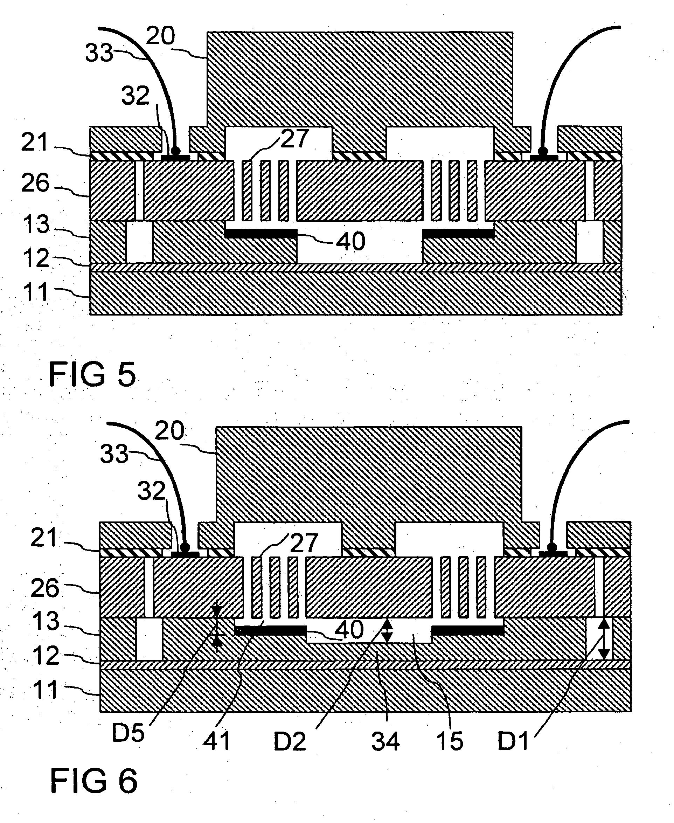

In Fig. 5 ist dargestellt, dass durch die zweistufige Strukturierung auch vergrabene Elektroden 40 realisiert werden können, mit welchen in erster Linie Bewegungen und Kräfte in z-Richtung (senkrecht zur Waferebene) detektiert bzw. eingeprägt werden können.

Durch eine dreistufige Strukturierung mit fünften Vertiefungen 41 mit einer fünften Ätztiefe D5, deren Ergebnis in Figur 6 dargestellt ist, können sowohl vergrabene Elektroden 40 als auch Leiterbahnbrücken 34 realisiert werden.

Die vergrabenen Elektroden 40 werden dabei beispielsweise durch das Material der entsprechenden Schicht (die Deckschicht 13) selbst, oder auch durch Abscheiden einer zusätzlichen Metallisierungsschicht auf der entsprechenden Schicht (der Deckschicht 13) realisiert.

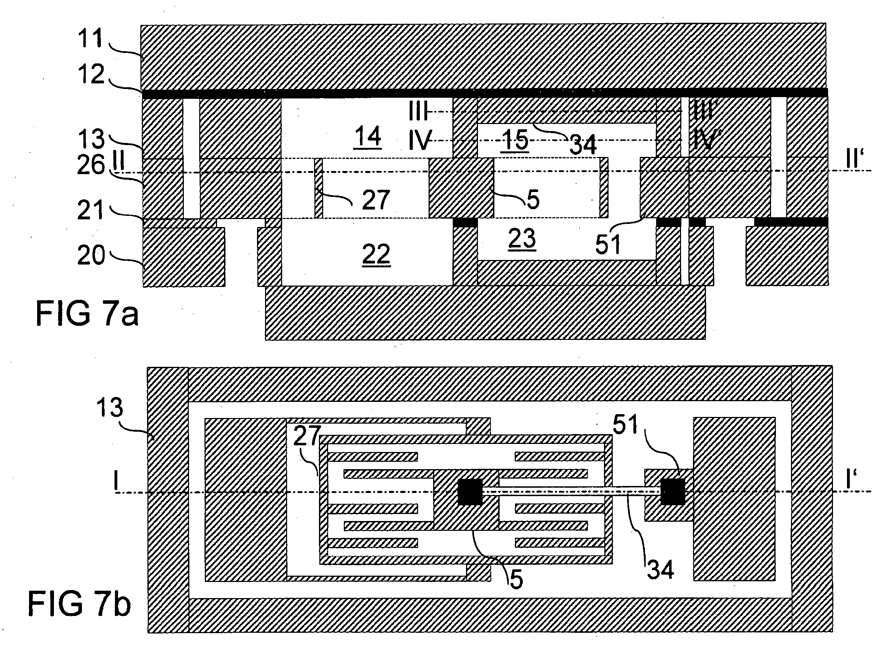

In Fig. 7a und 7b ist zur besseren Erläuterung eine weitere Darstellung eines Bauteils gezeigt. Dabei stellt die Figur 7a einen schematischen Schnitt entlang der Schnittfläche I-I' der Fig. 7b dar, während Figur 7b einen schematischen Querschnitt entlang der Schnittfläche II-II' der Fig. 7a zeigt, überlagert von einem Schnitt entlang der Fläche III-III' der Figur 7a (heller Grauton) und einem Schnitt entlang der Fläche IV-IV' der Figur 7a (dunkler Grauton). Dabei ist besonders gut im Querschnitt der Fig. 7b die aktive Struktur 27 und die Leiterbahnbrücke 34 gezeigt, welche eine Elektrode 5, die sich innerhalb der aktiven Struktur befindet, mit einem Anschluss 51 außerhalb der aktiven Struktur verbindet. Das dargestellte Bauteil zeigt dabei auch ein Beispiel dafür, dass sich ein Teil der ersten Vertiefungen 14 und der dritten Vertiefungen 22 symmetrisch ober- bzw. unterhalb der aktiven Struktur befinden, wie auch die zweiten Vertiefungen 15 und die vierten Vertiefungen 23. Bei einer symmetrischen Anordnung durch gleiche Ätztiefen der zweiten und vierten Vertiefungen 15, 23 sowie der ersten und dritten Vertiefungen 14. 22 ergibt sich eine symmetrische Gas-Umgebung der beweglichen aktiven Struktur 27. Dadurch werden resultierende Dämpfungskräfte senkrecht zur Ebene der Schichten und daraus resultierende parasitäre Bewegungen weitgehend unterdrückt.

## Patentansprüche

1. Verfahren zum Herstellen eines Bauteils (2), insbesondere eines mikromechanischen, mikro-elektromechanischen oder mikro-opto-elektromechanischen Bauteils, mit folgenden Schritten:
- Erzeugen eines ersten Schichtverbundes (10), der ein erstes Substrat (11), auf diesem eine erste Isolationsschicht (12) und auf dieser eine zumindest teilweise leitfähige Deckschicht (13) aufweist,
- Erzeugen von ersten Vertiefungen (14) und zweiten Vertiefungen (15) in der Deckschicht (13), wobei die ersten Vertiefungen (14) eine erste Ätztiefe und die zweiten Vertiefungen (15) eine gegenüber der ersten Ätztiefe geringere zweite Ätztiefe aufweisen, und die erste Ätztiefe mindestens gleich der Dicke der Deckschicht (13) ist und die zweite Ätztiefe kleiner als die Dicke der Deckschicht (13) ist,
- Aufbringen einer zumindest teilweise leitfähigen Strukturschicht (26) auf die Deckschicht (13), derart, dass die Strukturschicht (26) zumindest bereichsweise an die Deckschicht (13), die ersten Vertiefungen (14) und die zweiten Vertiefungen (15) angrenzt,
- Erzeugen einer aktiven Struktur (27) des Bauteils (2) durch Strukturieren der Strukturschicht (26), und
- In der Deckschicht (13) durch Erzeugen der zweiten Vertiefungen (15) Erzeugen einer Leiterbahnbrücke (34) über die aktive Struktur (27), welche eine Elektrode (5) der Strukturschicht (26) innerhalb der aktiven Struktur (27) mit der Strukturschicht (26) außerhalb der aktiven Struktur (27) verbindet, wobei
die zweite Ätztiefe den Abstand zwischen der Leiterbahnbrücke (34) und der aktiven Struktur (27) bestimmt.

2. Verfahren zum Herstellen eines Bauteils (2) nach Anspruch 1,
**dadurch gekennzeichnet, dass**
das Strukturieren der Strukturschicht (26) zur Erzeugung der aktiven Struktur (27) vor oder nach Aufbringen der Strukturschicht (26) auf die Deckschicht (13) erfolgt.

3. Verfahren zum Herstellen eines Bauteils (2), nach Anspruch 1,
**dadurch gekennzeichnet, dass**
auf der der Deckschicht (13) gegenüberliegenden Oberfläche der Strukturschicht (26) bereichsweise Metall-Kontaktierungsflächen (32) erzeugt werden.

4. Verfahren zum Herstellen eines Bauteils (2) nach Anspruch 3,
**dadurch gekennzeichnet, dass**
auf die der Deckschicht (13) gegenüberliegende Oberfläche der Strukturschicht (26) eine Kapselschicht (z.B. 20) zum Kapseln der aktiven Struktur (27) aufgebracht wird und dass
die Kapselschicht (z.B. 20) vor Aufbringen auf die Deckschicht (13) mit Kontaktlöchern (36) versehen wird, die nach dem Aufbringen der Kapselschicht (z.B. 20) auf die Deckschicht (13) einen Zugang zu den Metall-Kontaktierungsflächen (32) ermöglichen.

5. Verfahren zum Herstellen eines Bauteils (2) nach Anspruch 1 oder 3,
**dadurch gekennzeichnet, dass**
die Strukturschicht (26) durch folgende Schritte auf die Deckschicht (13) aufgebracht wird:
- Erzeugen eines zweiten Schichtverbundes (25), der ein zweites Substrat (20) und eine zweite Isolationsschicht (21), die wenigstens einen Teil der Oberfläche des zweiten Substrats (20) bedeckt, umfasst,
- Aufbringen der Strukturschicht (26) auf die zweite Isolationsschicht (21) und
- Aufbringen des zweiten Schichtverbundes (25) auf die Deckschicht (13) derart, dass die Strukturschicht (26) zumindest bereichsweise an die Deckschicht (13) angrenzt.

6. Verfahren zum Herstellen eines Bauteils (2) nach Anspruch 5,
**dadurch gekennzeichnet, dass**
das Strukturieren der Strukturschicht (26) zur Erzeugung der aktiven Struktur (27) vor oder nach Aufbringen der Strukturschicht (26) auf den zweiten Schichtverbund (25) erfolgt und dass
der erste und der zweite Schichtverbund (10. 25) sowie die Strukturschicht (26) so ausgestaltet werden, dass nach dem Aufbringen des zweiten Schichtverbunds (25) zumindest ein Teil der Strukturschicht (26), der die aktive Struktur (27) beinhaltet, durch den ersten und zweiten Schichtverbund (10, 25) hermetisch dicht verschlossen wird.

7. Verfahren zum Herstellen eines Bauteils (2) nach Anspruch 5 oder 6,
**dadurch gekennzeichnet, dass**
Kontaktlöcher (36) in dem zweiten Substrat (20) ausgebildet werden und dass
in der der Strukturschicht (26) zugewandten Seite des zweiten Substrats (20) vor Aufbringen der Strukturschicht (26) auf den zweiten Schichtverbund (25) dritte Vertiefungen (22) erzeugt werden, deren laterale Positionen wenigstens teilweise den lateralen Positionen der Kontaktlöcher (36) entsprechen, die später im zweiten Substrat (20) ausgebildet werden.

8. Verfahren nach Anspruch 7,
**dadurch gekennzeichnet, dass**
in der der Strukturschicht (26) zugewandten Seite des zweiten Substrats (20) vor Aufbringen der Strukturschicht (26) auf den zweiten Schichtverbund (25) vierte Vertiefungen (23) erzeugt werden, deren laterale Positionen wenigstens teilweise den lateralen Positionen der aktiven Struktur (27) der Strukturschicht (26) entsprechen.

9. Verfahren nach Anspruch 8,
**dadurch gekennzeichnet, dass**
die Ätztiefe der vierten Vertiefungen (23) zumindest näherungsweise gleich der zweiten Ätztiefe (D2) der zweiten Vertiefungen (15) der Deckschicht (13) gewählt wird.

10. Verfahren nach einem der Ansprüche 1 bis 9,
**dadurch gekennzeichnet, dass**
die unterschiedlichen ersten (D1) und zweiten Ätztiefen (D2) der ersten Vertiefungen (14) und zweiten Vertiefungen (15) und/oder die unterschiedlichen dritten (D3) und vierten Ätztiefen (D4) der dritten Vertiefungen (22) und vierten Vertiefungen (23) durch einen zweistufigen Trockenätzschritt durch eine Doppelmaske (16,17) erzeugt werden.

11. Verfahren nach einem der Ansprüche 1 bis 10,
**dadurch gekennzeichnet, dass**
in der Deckschicht (13) fünfte Vertiefungen (41) mit einer fünften Ätztiefe (D5), die sich von der ersten Ätztiefe (D1) und der zweiten Ätztiefe (D2) unterscheidet, realisiert werden und dass
an den Positionen der fünften Vertiefungen (41) in/auf der Deckschicht (13) Elektroden (40) für die aktive Struktur (27) erzeugt werden.

12. Mikromechanisches, mikro-elektromechanisches oder mikro-optoelektromechanisches Bauteil (2), mit:
- einem ersten Schichtverbund (10), der ein erstes Substrat (11), auf diesem eine erste Isolationsschicht (12) und auf dieser eine zumindest teilweise leitfähige Deckschicht (13) aufweist,
- einer zumindest teilweise leitfähigen Strukturschicht (26), die auf der Deckschicht (13) angeordnet ist und zumindest bereichsweise an die Deckschicht (13) angrenzt, und
- von einer Grenzfläche zur Strukturschicht (26) ausgehenden ersten Vertiefungen (14) und zweiten Vertiefungen (15) in der Deckschicht (13), wobei die ersten Vertiefungen (14) eine erste Ätztiefe (D1) und die zweiten Vertiefungen (15) eine gegenüber der ersten Ätztiefe (D1) geringere zweite Ätztiefe (D2) aufweisen, und die erste Ätztiefe (D1) mindestens gleich der Dicke der Deckschicht (13) ist und die zweite Ätztiefe kleiner als die Dicke der Deckschicht (13) ist,
wobei eine aktive Struktur (27) des Bauteils (2) durch Strukturieren der Strukturschicht (26) ausgebildet ist;
in der Deckschicht (13) durch die zweiten Vertiefungen (15) mindestens eine Leiterbahnbrücke (34) über die aktive Sturktur ausgebildet ist, welche eine Elektrode (5) der Strukturschicht (26) innerhalb der aktiven Struktur (27) mit der Strukturschicht (26) außerhalb der aktiven Struktur (27) verbindet: und
die zweite Ätztiefe den Abstand zwischen der Leiterbahnbrücke (34) und der aktiven Struktur (27) bestimmt.

13. Bauteil (2) nach Anspruch 12,
**gekennzeichnet durch**
Metall-Kontaktierungsflächen (32) auf der der Deckschicht (13) gegenüberliegenden Oberfläche der Strukturschicht (26) und dass
eine Kapselschicht (z.B. 20) zum Kapseln der aktiven Struktur (27) auf der der Deckschicht (13) gegenüberliegenden Oberfläche der Strukturschicht (26) und
Kontaktlöcher (36) in der Kapselschicht (z.B. 20) zum Ermöglichen eines Zugangs zu den Metall-Kontaktierungsflächen (32) vorgesehen sind.

14. Bauteil (2) nach einem der Ansprüche 12 oder 13,
**gekennzeichnet durch**
einen zweiten Schichtverbund (25), der ein zweites Substrat (20) und eine zweite Isolationsschicht (21), die wenigstens einen Teil der Oberfläche des zweiten Substrats (20) bedeckt, aufweist, wobei der zweite Schichtverbund (25) auf der der Deckschicht (13) gegenüberliegenden Seite der Strukturschicht (26) angeordnet ist.

15. Bauteil (2) nach Anspruch 14,
**dadurch gekennzeichnet, dass**
der erste und der zweite Schichtverbund (10, 25) sowie die Strukturschicht (26) so ausgestaltet sind, dass ein Teil der Strukturschicht (26), der die aktive Struktur (27) beinhaltet, durch den ersten und zweiten Schichtverbund (10, 25) hermetisch dicht verschlossen ist.

16. Bauteil (2) nach Anspruch 14 oder 15,
**dadurch gekennzeichnet, dass**
Kontaktlöcher (36) in dem zweiten Substrat (20) ausgebildet sind und dass
in der der Strukturschicht (26) zugewandten Seite des zweiten Substrats (20) dritte Vertiefungen (22) vorhanden sind, deren laterale Positionen wenigstens teilweise den lateralen Positionen der Kontaktlöcher (36) entsprechen.

## Claims

1. A method for producing a component (2), in particular a micromechanical, micro-electromechanical or micro-opto-electromechanical component, comprising the following steps:
- production of a first layer assembly (10), which has a first substrate (11), on the latter a first insulation layer (12) and on the latter an at least partly conductive covering layer (13),
- production of first depressions (14) and second depressions (15) in the covering layer (13), wherein the first depressions (14) have a first etching depth and the second depressions (15) have a second etching depth, which is smaller than the first etching depth, and the first etching depth is at least equal to the thickness of the covering layer (13) and the second etching depth is smaller than the thickness of the covering layer,
- application of an at least partly conductive structure layer (26) to the covering layer (13), in such a way that the structure layer (26) adjoins the covering layer (13), the first depression (14) and the second depression at least in regions
- production of an active structure (27) of the component (2) by patterning the structure layer (26); and
- by production of the second depression (15) in the covering layer (13) production of an interconnect bridge (34) across the active structure (27), which connects an electrode (5) of the structure layer (26) within the active structure (27) to the structure layer (26) outside the active structure (27), wherein
the second etching depth determines the distance between the interconnect bridge (34) and the active structure (27).

2. The method for producing a component (2) as claimed in claim 1,
**characterized in that**
the patterning of the structure layer (26) for production of the active structure (27) is effected before or after the application of the structure layer (26) to the covering layer (13).

3. The method for producing a component (2) as claimed in claim 1,
**characterized in that**
metal contact-making areas (32) are produced in regions on the surface of the structure layer (26) opposite to the covering layer (13).

4. The method for producing a component (2) as claimed in claim 3,
**characterized in that**
an encapsulation layer (e.g. 20) for encapsulating the active structure (27) is applied to the surface of the structure layer (26) opposite to the covering layer (13) and that
the encapsulation layer (e.g. 20), before being applied to the covering layer (13), is provided with contact holes (36) that enable access to the metal contact-making areas (32) after the encapsulation layer (e.g. 20) has been applied to the covering layer (13).

5. The method for producing a component (2) as claimed in claim 1 or 3, **characterized in that**
the structure layer (26) is applied to the covering layer (13) by means of the following steps:
- production of a second layer assembly (25), which comprises a second substrate (20) and a second insulation layer (21), which covers at least part of the surface of the second substrate (20),
- application of the structure layer (26) to the second insulation layer (21), and
- application of the second layer assembly (25) to the covering layer (13) in such a way that the structure layer (26) adjoins the covering layer (13) at least in regions.

6. The method for producing a component (2) as claimed in claim 5,
**characterized in that**
the patterning of the structure layer (26) for production of the active structure (27) is effected before or after the application of the structure layer (26) to the second layer assembly (25), and that
the first and the second layer assemblies (10, 25) and also the structure layer (26) are configured such that after the application of the second layer assembly (25), at least a part of the structure layer (26) which comprises the active structure (27) is hermetically tightly sealed by the first and second layer assemblies (10, 25).

7. The method for producing a component (2) as claimed in claim 5 or 6,
**characterized in that**
contact holes (36) are formed in the second substrate (20, and that
in the side of the second substrate (20) facing the structure layer (26), before the application of the structure layer (26) to the second layer assembly (25), third depressions (22) are produced, the lateral positions of which correspond at least in part to the lateral positions of the contact holes (36) that are formed later in the second substrate (20).

8. The method as claimed in claim 7,
**characterized in that**
in the side of the second substrate (20) facing the structure layer (26), before the application of the structure layer (26) to the second layer assembly (25), fourth depressions (23) are produced, the lateral positions of which correspond at least in part to the lateral positions of the active structure (27) of the structure layer (26).

9. The method as claimed in claim 8,
**characterized in that**
the etching depth of the fourth depressions (23) is chosen to be at least approximately equal to the second etching depth (D2) of the second depressions (15) of the covering layer (13).

10. The method as claimed in any of claims 1 to 9,
**characterized in that**
the different first (D1) and second etching depths (D2) of the first depressions (14) and second depressions (15) and/or the different third (D3) and fourth etching depths (D4) of the third depressions (22) and fourth depressions (23) are produced by means of a two-stage dry etching step by means of a double mask (16, 17).

11. The method as claimed in any of claims 1 to 10,
**characterized in that**
fifth depressions (41) having a fifth etching depth (D5), which differs from the first etching depth (D1) and the second etching depth (D2), are realized in the covering layer (13), and **in that**
electrodes (40) for the active structure (27) are produced at the positions of the fifth depressions (41) in/on the covering layer (13).

12. A micromechanical, micro-electromechanical or micro-opto-electromechanical component (2), comprising:
- a first layer assembly (10), which has a first substrate (11), on the latter a first insulation layer (12) and on the latter an at least partly conductive covering layer (13),
- an at least partly conductive structure layer (26) arranged on the covering layer (13) and adjoining the covering layer (13) at least in regions, and
- first depressions (14) and second depressions (15) in the covering layer (13), said depressions proceeding from an interface with the structure layer (26), wherein the first depressions (14) have a first etching depth (D1) and the second depressions (15) have a second etching depth (D2), which is smaller than the first etching depth (D1), and the first etching depth (D1) is at least equal to the thickness of the covering layer (13) and the second etching depth is smaller than the thickness of the covering layer (13),
wherein an active structure (27) of the component (2) is formed by patterning the structure layer (26);
by production of the second depression (15) in the covering layer (13) an interconnect bridge (34) across the active structure (27) is formed, which connects an electrode (5) of the structure layer (26) within the active structure (27) to the structure layer (26) outside the active structure (27); and
the second etching depth determines the distance between the interconnect bridge (34) and the active structure (27).

13. The component (2) as claimed in claim 12,
**characterized by**
metal contact-making areas (32) on the surface of the structure layer (26) opposite to the covering layer (13) and in that
an encapsulation layer (e.g. 20) for encapsulating the active structure (27) on the surface of the structure layer (26) opposite to the covering layer (13) and
contact holes (36) in the encapsulation layer (e.g. 20) for enabling access to the metal contact-making areas (32) are provided.

14. The component (2) as claimed in claim 12 or 13,
**characterized by**
a second layer assembly (25), which has a second substrate (20) and a second insulation layer (21), which covers at least part of the surface of the second substrate (20), wherein the second layer assembly (25) is arranged on the side of the structure layer (26) opposite to the covering layer (13).

15. The component (2) as claimed in claim 14,
**characterized in that**
the first and the second layer assemblies (10, 25) and also the structure layer (26) are configured such that a part of the structure layer (26) which comprises the active structure (27) is hermetically tightly sealed by the first and second layer assemblies (10, 25).

16. The component (2) as claimed in claim 14 or 15,
**characterized in that**
contact holes (36) are formed in the second substrate (20) and that
in the side of the second substrate (20) facing the structure layer (26), third depressions (22) are present, the lateral positions of which correspond at least in part to the lateral positions of the contact holes (36).

## Revendications

1. Procédé pour produire un composant (2), en particulier un composant micromécanique, microélectromécanique ou micro-opto-électromécanique, avec les étapes suivantes :
- production d'un premier composite stratifié (10) qui comprend un premier substrat (11), sur celui-ci une première couche isolante (12), et sur celle-ci une couche de recouvrement (13) au moins en partie conductrice,
- production de premiers creux (14) et de deuxièmes creux (15) dans la couche de recouvrement (13), étant précisé que les premiers creux (14) présentent une première profondeur de gravure, et les deuxièmes creux (15) une deuxième épaisseur de gravure, plus faible que la première, et que la première épaisseur de gravure est au moins égale à l'épaisseur de la couche de recouvrement (13) tandis que la deuxième épaisseur de gravure est inférieure à l'épaisseur de la couche de recouvrement (13),
- application d'une couche de structure (26) au moins en partie conductrice sur la couche de recouvrement (13), de telle sorte que la couche de structure (26) soit au moins par zones voisine de ladite couche de recouvrement (13), des premiers creux (14) et des deuxièmes creux (15),
- production d'une structure active (27) du composant (2) par structuration de la couche de structure (26), et
- dans la couche de recouvrement (13), grâce à la production des deuxièmes creux (15), production d'un pont de piste conductrice (34) au-dessus de la structure active (27), qui relie l'électrode (5) de la couche de structure (26) située à l'intérieur de la structure active (27), à la couche de structure (26) située à l'extérieur de ladite structure active (27), étant précisé que
la deuxième profondeur de gravure définit la distance entre le pont de piste conductrice (34) et la structure active (27).

2. Procédé pour produire un composant (2) selon la revendication 1, **caractérisé en ce que** la structuration de la couche de structure (26) pour produire la structure active (27) a lieu avant ou après l'application de la couche de structure (26) sur la couche de recouvrement (13).

3. Procédé pour produire un composant (2) selon la revendication 1, **caractérisé en ce que** des surfaces de contact métalliques (32) sont produites, par zones, sur la surface de la couche de structure (26) opposée à la couche de recouvrement (13).

4. Procédé pour produire un composant (2) selon la revendication 3, **caractérisé**
**en ce qu'**une couche d'encapsulation (par exemple 20) est appliquée sur la surface de couche de structure (26) opposée à la couche de recouvrement (13), afin d'encapsuler la structure active (27), et
**en ce que** la couche d'encapsulation (par exemple 20) est pourvue, avant son application sur la couche de recouvrement (13), de trous de contact (36) qui, après l'application de ladite couche d'encapsulation (par exemple 20), permettent un accès aux surfaces de contact métalliques(32).

5. Procédé pour produire un composant (2) selon la revendication 1 ou 3, **caractérisé en ce que** la couche de structure (26) est appliquée sur la couche de recouvrement (13) grâce aux étapes suivantes :
- production d'un deuxième composite stratifié (25) qui comprend un deuxième substrat (20) et une deuxième couche isolante (21) qui couvre une partie au moins de la surface du deuxième substrat (20),
- application de la couche de structure (26) sur la deuxième couche isolante (21) et
- application du deuxième composite stratifié (25) sur la couche de recouvrement (13) de telle sorte que la couche de structure (26) soit au moins par zones voisine de ladite couche de recouvrement (13).

6. Procédé pour produire un composant (2) selon la revendication 5, **caractérisé**
**en ce que** la structuration de la couche de structure (26) pour produire la structure active (27) a lieu avant ou après l'application de la couche de structure (26) sur la couche de recouvrement (13), et
**en ce que** les premier et deuxième composites (10, 25) ainsi que la couche de structure (26) sont conçus de telle sorte qu'après l'application du deuxième composite stratifié (25), une partie au moins de la couche de structure (26) qui contient la structure active (27) soit fermée hermétiquement par les premier et deuxième composites (10, 25).

7. Procédé pour produire un composant (2) selon la revendication 5 ou 6, **caractérisé**
**en ce que** des trous de contact (36) sont formés dans le deuxième substrat (20), et
**en ce que** dans le côté du deuxième substrat (20) tourné vers la couche de structure (26) sont formés, avant l'application de la couche de structure (26) sur le deuxième composite stratifié (25), des troisièmes creux (22) dont les positions latérales correspondent au moins en partie aux positions latérales des trous de contact (36) qui sont formés plus tard dans le deuxième substrat (20).

8. Procédé selon la revendication 7, **caractérisé en ce que** dans le côté du deuxième substrat (20) tourné vers la couche de structure (26) sont formés, avant l'application de la couche de structure (26) sur le deuxième composite stratifié (25), des quatrièmes creux (23) dont les positions latérales correspondent au moins en partie aux positions latérales de la structure active (27) de la couche de structure (26).

9. Procédé selon la revendication 8, **caractérisé en ce que** la profondeur de gravure des quatrièmes creux (23) est choisie pour être au moins approximativement égale à la deuxième profondeur de gravure (D2) des deuxièmes creux (15) de la couche de recouvrement (13).

10. Procédé selon l'une des revendications 1 à 9, **caractérisé en ce que** les différentes première (D1) et deuxième (D2) profondeurs de gravure des premiers creux (14) et des deuxièmes creux (15) et/ou les différentes troisième (D3) et quatrième (D4) profondeurs de gravure des troisièmes creux 22) et des quatrièmes creux (23) sont produites par une étape de gravure sèche en deux phases, grâce à un masque double (16, 17).

11. Procédé selon l'une des revendications 1 à 10, **caractérisé**
**en ce que** des cinquièmes creux (41) d'une cinquième profondeur de gravure (D5), différente de la première profondeur de gravure (D1) et de la deuxième profondeur de gravure (D2), sont réalisés dans la couche de recouvrement (13), et
**en ce qu'**au niveau des positions des cinquièmes creux (41) dans/sur la couche de recouvrement (13) sont produites des électrodes (40) pour la structure active (27).

12. Composant micromécanique, microélectromécanique ou micro-opto-électromécanique (2), avec :
- un premier composite stratifié (10) qui comprend un premier substrat (11), sur celui-ci une première couche isolante (12), et sur celle-ci une couche de recouvrement (13) au moins en partie conductrice,
- une couche de structure (26) au moins en partie conductrice qui est disposée sur la couche de recouvrement (13) et qui est au moins par zones voisine de ladite couche de recouvrement (13), et
- des premiers creux (14) et des deuxièmes creux (15) dans la couche de recouvrement (13), qui partent d'une interface avec la couche de structure (26), étant précisé que les premiers creux (14) présentent une première profondeur de gravure (D1), et les deuxièmes creux (15) une deuxième épaisseur de gravure (D2), plus faible que la première épaisseur de gravure (D1), et que la première épaisseur de gravure (D1) est au moins égale à l'épaisseur de la couche de recouvrement (13) tandis que la deuxième épaisseur de gravure est inférieure à l'épaisseur de la couche de recouvrement (13),
étant précisé qu'une structure active (27) du composant (2) est formée grâce à une structuration de la couche de structure (26) ;
que dans la couche de recouvrement (13), grâce aux deuxièmes creux (15), est formé au-dessus de la structure active au moins un pont de piste conductrice (34), qui relie une électrode (5) de la couche de structure (26) située à l'intérieur de la structure active (27), à la couche de structure (26) située à l'extérieur de ladite structure active (27), et
que la deuxième profondeur de gravure définit la distance entre le pont de piste conductrice (34) et la structure active (27).

13. Composant (2) selon la revendication 1, **caractérisé**
**par** des surfaces de contact métalliques (32) sur la surface de la couche de structure (26) opposée à la couche de recouvrement (13), et
en ce qu'il est prévu une couche d'encapsulation (par exemple 20) pour encapsuler la structure active (27), sur la surface de couche de structure (26) opposée à la couche de recouvrement (13), et
des trous de contact (36) dans la couche d'encapsulation (par exemple 20), pour permettre un accès aux surfaces de contact métalliques (32).

14. Composant (2) selon l'une des revendications 12 ou 13, **caractérisé par**
un deuxième composite stratifié (25) qui comprend un deuxième substrat (20) et une deuxième couche isolante (21) qui couvre une partie au moins de la surface du deuxième substrat (20), étant précisé que le deuxième composite stratifié (25) est disposé sur le côté de la couche de structure (26) opposé à la couche de recouvrement (13).

15. Composant (2) selon la revendication 14, **caractérisé**
**en ce que** les premier et deuxième composites (10, 25) ainsi que la couche de structure (26) sont conçus de telle sorte qu'une partie de la couche de structure (26) qui contient la structure active (27) soit fermée hermétiquement par les premier et deuxième composites (10, 25).

16. Composant (2) selon la revendication 14 ou 15, **caractérisé**
**en ce que** des trous de contact (36) sont formés dans le deuxième substrat (20), et
**en ce qu'**il est prévu, dans le côté du deuxième substrat (20) tourné vers la couche de structure (26), des troisièmes creux (22) dont les positions latérales correspondent au moins en partie aux positions latérales des trous de contact (36).
